(19) **Europäisches Patentamt**
**European Patent Office**
**Office européen des brevets**

(11) **EP 1 657 592 A2**

(12) **EUROPEAN PATENT APPLICATION**

(43) Date of publication:
**17.05.2006 Bulletin 2006/20**

(51) Int Cl.:
***G03F 1/00*** *(2006.01)*

(21) Application number: **05077525.3**

(22) Date of filing: **03.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **10.11.2004 US 985343**

(71) Applicant: **FEI COMPANY**
**Hillsboro, Oregon 97124-5793 (US)**

(72) Inventors:
• **Moriarty, Michael Herve**
**Worcester (MA) 01604 (US)**
• **Graupera, Armand Anthony**
**Bedford (MA) 01730 (US)**

(74) Representative: **Bakker, Hendrik**
**FEI Company,**
**Patent Department,**
**Postbus 80066**
**5600 KA Eindhoven (NL)**

(54) **Method of depositing a material providing a specified attenuation and phase shift**

(57) The invention allows for the control of the attenuation and the phase of light transmitted through a deposited material. The invention is particularly applicable to the repair of attenuated phase shift photomasks. The transmission and the phase of the repaired area can be controlled. In a preferred embodiment, the phase of light transmitted through the repaired area is controlled by controlling the thickness of a deposited material, and the transmissivity of the repaired area is controlled by controlling the introduction of a contaminant into the repair area.

```
┌──────────────────────────────────────────────┐
│ Determine phase shift and attenuation required │  402
│ of repair                                       │
└──────────────────────────────────────────────┘
                      ↓
┌──────────────────────────────────────────────┐
│ Estimate thickness of deposited layer required │  404
│ to provide phase shift                          │
└──────────────────────────────────────────────┘
                      ↓
┌──────────────────────────────────────────────┐
│ Convert thickness values to doses              │  405
└──────────────────────────────────────────────┘
                      ↓
┌──────────────────────────────────────────────┐
│ Deposit material at multiple test sites        │  406
└──────────────────────────────────────────────┘
                      ↓
┌──────────────────────────────────────────────┐
│ Measure aerial image of test sites             │  408
└──────────────────────────────────────────────┘
                      ↓
┌──────────────────────────────────────────────┐
│ Plot intensity under test sites                │  410
└──────────────────────────────────────────────┘
                      ↓
┌──────────────────────────────────────────────┐
│ Define relationship between thickness and      │  412
│ intensity                                       │
└──────────────────────────────────────────────┘
                      ↓
┌──────────────────────────────────────────────┐
│ Determine thickness that minimizes intensity   │  414
└──────────────────────────────────────────────┘
                      ↓
                     (A)
```

**FIG. 4A**

EP 1 657 592 A2

```
                        ┌───┐
                        │ A │
                        └─┬─┘
                          ▼
```

| | |
|---|---|
| Deposit multiple large area varying dwell time and refresh time | ⌐ 420 |

↓

| | |
|---|---|
| Determine transmission from aerial image | ⌐ 422 |

↓

| | |
|---|---|
| Measure thickness | ⌐ 424 |

↓

| | |
|---|---|
| Determine relationship between proecss variables and deposition rate | ⌐ 425 |

↓

| | |
|---|---|
| Calculate attenuation per unit thickness | ⌐ 426 |

↓

| | |
|---|---|
| Determine relationship between process variables and attenuation per unit thickness | ⌐ 428 |

↓

| | |
|---|---|
| Determine required attenuation per unit thickness from required thickness (step 414) and desired attenuation | ⌐ 430 |

↓

| | |
|---|---|
| Determine process parameters from required attenuation per unit thickness and relationship found in step 428 | ⌐ 434 |

↓

| | |
|---|---|
| Determine ion dose based on thickness determine from step 426 and deposition rates from step 425 | ⌐ 436 |

↓

| | |
|---|---|
| Perform repair using process parameters from step 434 and dose from step 436 | ⌐ 438 |

# FIG. 4B

## Description

### Technical Field of the Invention

The present invention relates to a process for controlled deposition of a material to provide a specified attenuation and phase shift in light transmitted through the material, and is particularly suitable for use on an attenuated phase shift mask.

### Background of the Invention

One step in the fabrication of integrated circuits entails the use of lithography. A semiconductor substrate on which circuits are being formed is typically coated with a material, such as a photoresist, that changes solubility when exposed to radiation. A lithography medium, such as a mask or reticle, positioned between the radiation source and the semiconductor substrate casts a shadow to control which areas of the substrate are exposed to the radiation. After the exposure, the photoresist is removed from either the exposed or the unexposed areas, leaving a patterned layer of photoresist on the wafer that protects parts of the wafer during a subsequent etching or diffusion process.

The term mask is used generically herein to refer to any lithography tool, regardless of the type of exposing radiation and regardless of whether the image of the mask is printed once or stepped across the substrate. A mask typically comprises a patterned layer of an absorber material, such as chromium or molybdenum silicide, on a substrate, such as quartz.

As semiconductor manufacturers attempt to decrease the size of integrated circuits, the patterns that are be transferred to the surface of the semiconductor substrate become smaller and more complex. One problem with conventional masks at extremely small dimensions is that diffraction causes light to leak into areas that should be dark. This problem is particularly acute as the line widths in the patterns reaches sub-micron dimensions. At these dimensions, device line widths are so narrow that conventional light sources, and binary photomasks that include opaque areas and transparent areas to transfer the pattern cannot ensure the designs accurately print on the wafer.

One way to overcome this problem is to use phase shift masks, which are capable of sharpening the light's effects on photoresist for sub-micron designs. Phase shift masks change the phase of the portion of light passing through the mask, so that the peaks of the phase-shifted wave coincide with troughs of the non-phase shifted wave, and the waves in effect cancel each other out to produce darker dark areas. The phase-shifted light is said to destructively interfere with the non-phase shifted light.

Phase shift photomasks may include, in addition to patterned opaque chromium on quartz, complex three-dimensional (3D) reticle enhancement structures that provide a means to change the phase of light passing through different regions of the mask. The variants to 3D-reticle structures include alternating phase shifters—typically an etched region in the quartz substrate—and attenuated shifters—such as a layer of partially transmissive material, typically molybdenum silicide oxynitride ("MoSiON") or chrome oxide—on the quartz substrate.

When any type of photomask is manufactured, it is not unusual for the photomask to have defects. Since the cost of a set of advanced reticles for a semiconductor manufacturing process can approach $1 million, it is desirable to have a process capable of repairing defects in photomasks. For ordinary (non-phase shift) photomasks, there are essentially two defect types, opaque and clear. Clear defects are areas where absorber is missing from areas that should be opaque; opaque defects are areas having absorber material deposited in areas that should be clear. In addition to the clear and opaque defects found in ordinary masks, phase shift photomasks can also have defects in the etched substrate itself, such as a bump where excess substrate material is present, a divot or hole in the substrate, or missing attenuation phase-shift material.

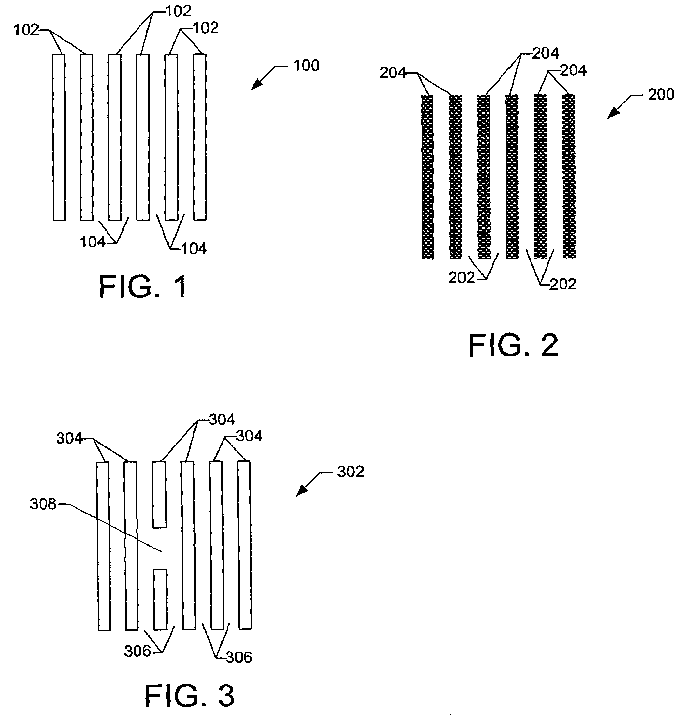

FIG. 1 shows a typical portion of an attenuating phase shift mask 100 that include a pattern of lines 102 of an attenuating phase shift material, such as MoSiON, on a quartz substrate 104. The MoSiON passes about six percent of the incident light and shifts the phase of incident light by about 180 degrees compared to light passing through the quartz substrate without passing through the MoSiON lines. Because of the diffraction of light, the shadow areas under the MoSiON lines are actually darker than the shadow areas under chrome lines that block all incident radiation. FIG. 2 shows the pattern 200 of light areas 202 and dark areas 204 resulting from projecting light through mask 100 in a photolitograph process. The pattern produced by the mask on a substrate is referred to as the mask's "aerial image."

FIG. 3 shows a mask 302 having a pattern including lines 304 of MoSiON on a quartz substrate 306, but with a defect -- an area 308 of missing MoSiON material. Mask defects themselves can be transferred as a part of the pattern and must be repaired before the photomask can be used.

Charged particle beam systems, such as focused ion beam systems (FIB), have traditionally been used to repair defects in photolithography masks. Focused ion beam systems are well known and are described, for example, in U.S. Pat. No. 6,709,554 for "Method and Apparatus for Repairing Lithography Masks Using a Charged Particle Beam System" which is assigned to FEI Company, Hillsboro, Oregon, the assignee of the present invention. Suitable focused ion beam systems include the Model Accura 850+ available from FEI Company.

Typically, when an FIB system is used to repair a defect in a photomask, a finely focused beam of gallium ions from a liquid metal ion source is first scanned across the photomask surface to form an image of the surface. The intensity at each point of the image is determined by the current of secondary electrons ejected by the ion beam at the corresponding point on the substrate. The defect is identified on the image, and the ion beam is then directed to the defect area to repair the defect, either by milling away the excess material or by decomposing a precursor gas to deposit missing opaque material. Precursor gases must have very specific properties, that is, they must adsorb to the surface and decompose only in the presence of the ion beam to form the material to be deposited and volatile by-products that will be removed from the vacuum chamber. The number of materials that can be deposited using FIB deposition is very limited. Using precursor gases that are activated by energy directed toward the substrate allows for local deposition, as opposed to a whole wafer or whole mask process, that deposits material in a controllable area significantly less than that of the entire substrate. In many embodiments, the locally deposited area is on the order of a micron or less and is comparable to the feature size on the work piece. The deposition can be in any shape as defined by the path of the activating energy beam.

Attenuation phase shift masks, also referred to as Embedded Phase Shift Masks (EPSM), present unique problems for mask repair. EPSMs typically include areas that block most of the light, and allow some of the light through with a phase shift. The small amount of light transmitted is insufficient to expose the photoresist beneath the material, but the phase shifted light interferes with the diffracted light from clear areas to produce darker shadowed areas. For example, a typical phase shift mask may include MoSiON on quartz. The MoSiON typically stops about ninety four percent of the incoming light, and the six percent that is transmitted is typically phase shifted 180 degrees.

Because there are no known precursor gases to deposit MoSiON by ion beam deposition, missing attenuation phase shift mask material is typically repaired by depositing an opaque material. Although a mask repaired with an opaque repair does not function as well as the original design using an attenuating phase shift material, the repair was practical and the results acceptable in many cases. As the specifications for masks become ever tighter, however, replacing attenuation phase shift material with opaque material is no longer acceptable.

## Summary of the Invention

An object of the invention is to locally deposit a material having specified phase shift and attenuation properties.

The invention allows for the control of the attenuation and the phase of a material deposited on a surface. The invention is particularly applicable to the repair of phase shift photomasks. The transmission and the phase of the repaired area can be controlled. In a preferred embodiment, the phase of light transmitted through the repaired area is controlled by varying the thickness of a deposited material, and the transmissivity of the repaired area is controlled by varying the amount of contaminant incorporated into the deposited material.

For a more thorough understanding of the present invention, and advantages thereof, reference is now made to the following descriptions taken in conjunction with the accompanying drawings, in which:

## Brief Description of the Drawings

FIG. 1 shows a portion of a photolithography mask having a pattern of lines and spaces.

FIG. 2 shows an ideal aerial image of the mask portion of FIG. 1.

FIG. 3 shows a mask pattern similar to that of FIG. 1 but having a defect of missing absorber material

FIGS. 4A and 4B shows the steps of a preferred method of characterizing process parameters and repairing a defect by depositing a material of a desired phase shift and attenuation

FIG. 5 shows a three dimensional image of a defect repaired by deposition of a material to provide a desired phase shift and attenuation

FIG. 6 shows a cross section of the repair of FIG. 5, with the vertical scale expanded.

FIG. 7 shows a cross section of the repair of FIG. 5.

FIG. 8 shows an aerial image of a repaired section.

FIG. 9 shows the light intensity along a line from the aerial image of FIG. 8.

FIG. 10 shows the relative transmission versus deposition thickness for several experimental points and shows a theoretical line fitted to the experimental points.

FIG. 11 shows a test pattern used to measure the attenuation at various process parameters.

FIG. 12 shows another test pattern used to measure the attenuation at various process parameters.

FIG. 13 shows the steps of repairing an attenuation phase shift mask in accordance with the invention after the process parameters have been characterized.

FIG. 14 describes a generalized process for determining process parameters.

**Detailed Description of Preferred Embodiments**

The invention provides a method for using a particle beam, a laser beam, or other energy source to deposit a compound with controlled transmittance and phase-shifting characteristics. The extent of the deposited area can be controlled by controlling the path of the beam that induces the deposition. The particle beam can be, for example, a focused ion beam, an electron beam, or a particle beam from a scanning probe microscope. Ion beam induced deposition of a transmissive material is described, for example, in US. Pat. No. 5,827,786 to Puretz for "Charged Particle Deposition of Electrically Insulating Films," which is assigned to the assignee of the present invention. The term "focused" is not limited to beams that are focused to a point on the target substrate, but includes shaped beams, defocused beams, and other beams that produce a spot size sufficiently small to deposit material in approximately the size of a defect. Also, the term ion beam can encompass a beam of particles that were accelerated and then neutralized.

Embodiments of the invention deposit a layer of material that causes a non-zero phase shift and use an additive, referred to as a "contaminant," incorporated into the layer to reduce the transmission, thereby providing a desired phase shift and a desired attenuation of less than 100 percent. In some embodiments of the invention, a technician produces the required attenuation by using specified process parameters to control the degree to which contaminants are embedded in the deposition. The contaminants can be intentionally injected into the system, such as by the introduction of a gas; can be a controlled byproduct of the deposition process, such as implanted gallium from a focused beam of gallium ions; or can be an environmental factor, such as carbon, which is typically unavoidably present at low concentrations from lubricants or seals in vacuum systems. The contaminant can be a combination of materials, and when applicants say that in some embodiments the contaminant can be gallium or carbon, the embodiment can also include both, that is, the "or" is not an "exclusive or."

This control over contaminants provides an additional, independent factor that can be controlled in addition to the thickness of the deposit, thereby allowing embodiments of the invention to independently control the transmissivity and phase shift of the deposition. For example, for a mask using an absorber of a given transmittance and phase-shift, there is a $SiO_x$ deposition with a thickness and proportional composition of gallium, carbon, or other contaminant that matches the transmittance and phase-shift of the absorber.

By characterizing the relationship between controllable process parameters, such as dose and pixel dwell time, and properties such as attenuation per unit thickness and phase-shift per unit thickness of deposited transmissive compounds, such as SiOx or nitrogen-oxygen-containing compounds, it is possible to determine the process parameters and ion, electron, light, or other energy doses necessary to repair defects of missing absorber on various phase shift masks (PSMs). In effect, the invention makes possible the creation of a "calculator" in which the desired phase and attenuation are input and the calculator outputs the necessary process in terms of dose and a second parameter or parameters, such as dwell time, that can plugged into an optimized process to deposit a material, such as SiOx, with the specified attenuation and phase shift. Thus, a technician can operate the mask repair equipment using some process settings that are optimized and remain constant over a range of repairs, and some settings that are varied to produce the desired attenuation and phase shift.

Several embodiments are described below to illustrate the principles of the invention. The embodiments below provide examples that allow skilled persons to extend the principals of the invention to additional applications still within the scope of the appended claims.

**Example 1**

One embodiment of the invention uses a FIB to induce a gas mixture of tetramethylcyclotetrasiloxane (TMCTS) and $O_2$ to deposit a layer of optically transmissive Si-O-Ga-C for the repair of missing MoSiON on a PSM. By adjusting the amount of gallium, carbon, or other contaminants in the deposition, this invention can match the optical characteristics for the replacement of material on a PSM. Carbon may be present in the vacuum system as an unintentional contaminant, or it can be introduced in a carbon containing gas.

For example, a FIB repair process tuned for the replacement of missing absorber on a 6% transmissive MoSiON PSM for 193 nm wavelength lithography could use the following parameters:

| Variable | Unit | Value |
|---|---|---|
| **Accel voltage** | kV | 30.0 |
| **TMCTS Pressure** | mbar | 1.0 |
| **O2 Pressure** | mbar | 4.0 |
| **Beam current** | pA | 6.0 |

Table continued

| Variable | Unit | Value |
|---|---|---|
| Repair area | $\mu$m^2 | 0.500 |
| Repair dose | nC/$\mu$m^2 | 0.165 |
| Pixel spacing | $\mu$m | 0.020 |
| Dwell time | $\mu$s | 0.200 |
| Refresh time | ms | 4.5 |

On a FIB photomask repair platform, such as FEI's Accura 850+, these parameters produce a $SiO_x$ deposition with a phase-shift near 180° and with a transmissivity around 6% of that of open quartz area at a lithographic wavelength of 193 nm.

A preferred method of determining the process parameters required to deposit material having the desired phase shift and attenuation in a process using FIB deposition with a TMCTS and oxygen is described in detail below after the examples.

## Example 2

This embodiment uses a FIB to induce any siloxane precursor, such as Dimethoxydimethylsilane, Octamethylcyclotetrasiloxane (OMCTS), or Pentamethylcyclopentasiloxane (PMCPS), to deposit a layer of optically transmissive material. By adjusting the amount of Gallium, Carbon, or other contaminants in the deposition, this embodiment can match the optical characteristics for the replacement of material on a PSM.

## Example 3

This embodiment uses an electron beam to induce a siloxane precursor, such as the ones described above in example 2, to deposit a layer of optically transmissive material. By adjusting process parameters that affect the amount of any unavoidable process or system contaminants that embed in the deposition, this embodiment matches the optical characteristics for the replacement of absorber material on a photomask.

## Example 4

Embodiments of the invention can extend the process described in Example 3 by intentionally introducing a contaminant, such as styrene gas or other carbon containing gas, into the process region in order to control the optical characteristics of the deposition.

One example of an electron beam repair process tuned for the replacement of missing absorber on a typical PSM could use parameters such as:

| Variable | Unit | Value |
|---|---|---|
| Accel voltage | kV | 5.0 |
| TSCMTS Pressure | mbar | 1.0 |
| O2 Pressure | mbar | 4.0 |
| Styrene Pressure | mbar | Variable to match absorber transmission |

## Example 5

Embodiments of the invention can use a laser to induce a siloxane precursor, such as those described above, to deposit a layer of optically transmissive material. By adjusting process parameters that affect the amount of any unavoidable process or system contaminants that embed in the deposition, this embodiment matches the optical characteristics for the replacement of material on a photomask.

### Example 6

This embodiment extends the embodiment of Example 5 by intentionally introducing a contaminant, such as a carbon containing gas as described in Example 4, into the process region in order to control the optical characteristics of the deposition.

Such a repair process could be implemented on a laser-based photomask repair tool using standard light frequencies and pixel spacings. This process would need to use a laser power per spot size and dwell time sufficient to cause precursor material to deposit on a photomask. The same optimization process described below with respect to FIB based deposition can be used to identify suitable energy dose, contaminant pressure, dwell time, and refresh time to match the transmissivity and phase shift of photomask absorber.

### Example 7

Instances of this embodiment can mix the precursor gases with oxygen- or nitrogen-containing gases (such as $O_2$, $N_2$, or $H_2O$) in the FIB, electron beam, or laser mask repair system to further control the optical properties of the induced deposition.

### Representative Determination of Process Parameters - Gallium FIB

### Deposition

Applicants describe below a method of determining the process parameters for an embodiment, similar to that of Example 1 above, that uses a focused ion beam to induce deposition of $SiO_x$ using a TMCTS precursor and oxygen to repair a MoSiON attenuated phase shift mask by depositing material to replace missing MoSiON, and to nearly match the phase shift and attenuation of the MoSiON.

A mask is originally created by depositing an unpatterned layer of MoSiON onto the quartz substrate and then removing MoSiON to form the mask pattern. Because MoSiON is not readily deposited locally in a controlled matter, a material other than MoSiON is deposited to produce approximately the same aerial image as the missing MoSiON. Because the optical properties, particularly the index of refraction and transmissivity, of the deposited material differ from those of the MoSiON, the deposited material will typically require a different thickness to produce the same phase shift and transmission as the missing absorber material.

By providing below a detailed teaching of how to determine process parameters for one embodiment, skilled persons can apply the teachings to determine process parameters for other embodiments, including those described above in example 2-8, as well as other embodiments.

In the example below, a focused beam of gallium ions is used to deposit a layer of a silicon oxide containing material, and the amount of gallium implanted into the area during deposition is controlled to provide the desired transmissivity.

Applicants have found that in some applications, the phase shift and attenuation can be adjusted independently, that is, the thickness of the deposition can be adjusted to provide a desired phase shift, and then a second process parameter or parameters can be adjusted to provide the required attenuation, without affecting the phase shift to an unacceptable degree. The invention also provides for situations in which the phase shift and attenuation cannot be independently determined, for example, when changing process parameters to adjust one characteristic affects the other. For example, in some cases, changing the concentration of the contaminant may change the index of refraction of the deposited material, which will alter the thickness required to provide the necessary phase shift.

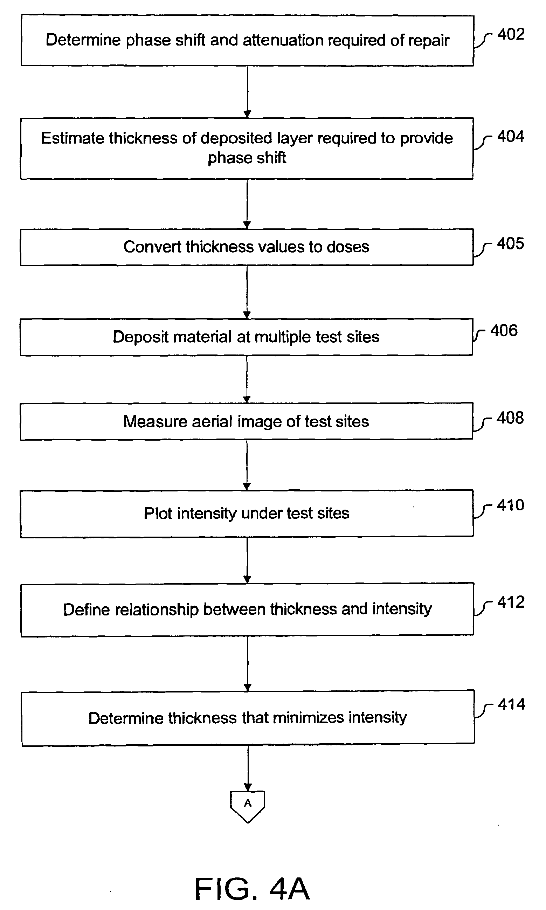

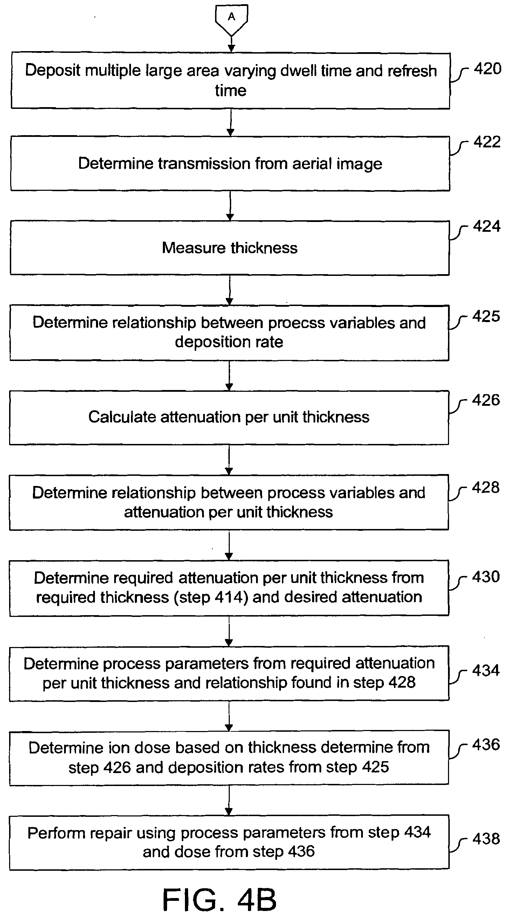

One preferred method is shown in FIG. 4A and 4B. The method of FIG. 4A and 4B assumes that the index of refraction is substantially independent of the concentration of implanted gallium. In step 402, the desired phase shift and attenuation of the repaired area is determined from the specification of the original mask. In step 404, an estimated thickness of a deposited layer is determined by using an estimated value of the index of refraction of the material to be deposited and the design phase shift. The thickness to produce a desired phase shift can be estimated from

$$T = [n + (\phi / 2 \pi)] * [\lambda / (N - 1)]$$

in which T is thickness required, $\phi$ is the phase shift desired, N is the index of refraction of the deposited material, $\lambda$ is the wavelength in a vacuum of light used, and n is an integer. This equation assumes that the index of refraction of the transmission medium surrounding the mask is close to the refractive index of vacuum, which is an acceptable approximation for the typical case of air. Skilled persons can readily adapt this calculation to immersion lithography systems by using an analogous equation, known from the scientific literature, that accounts for the refractive index of the immersion fluid. Multiple values of T can be used to provide any desired phase shift. It is desirable to choose n = 0 to obtain the thinnest layer that will provide the desired phase shift. A thicker layer may unacceptably reduce the transmission. Alternatively, one could determine the required thickness of the deposited material by multiplying the thickness of the original phase shift material by the ratio of the index of refraction of the original material minus unity to the index of refraction of the material to be deposited minus unity. In step 405, the thickness values are converted into the ion dose values that are required to deposit the necessary thicknesses. Skilled persons can readily determine the ion dose corresponding to a specified thickness based on the deposition rate.

In step 406, material is deposited at multiple test sites. The material deposited at each test site has a different thickness, with the range of thicknesses bracketing the estimated thickness that would produce the desired phase shift. Each test site is on a test mask pattern that includes multiple lines of absorber material with missing sections to simulate a defect, like the one shown in FIG. 3. In one application, applicants used a series of programmed "defects" of missing MoSiON, the missing areas were 1.0 $\mu$m long in a pattern of 520 nm lines separated by 520 nm spaces.

An ion beam was used to induce deposition at each test site. Skilled persons can readily determine suitable ion beam parameters. In one example, the ion beam was operated at an accelerating voltage of 30 kV with a 15 $\mu$m aperture and a beam current of about 2.7 pA. The deposition gas was TMCTS at a pressure of 1.0 mbar and oxygen at a pressure of 4.0 mbar. A pixel spacing of 0.020 $\mu$m with a dwell time of 0.2 $\mu$s and a raster time of 264 $\mu$s were used. Skilled persons can readily adjust the process parameters for a particular application. For example, a dosage range from about 0.072 nC/$\mu$m$^2$ to about 0.200 nC/$\mu$m$^2$ was used to deposit material of various thicknesses.

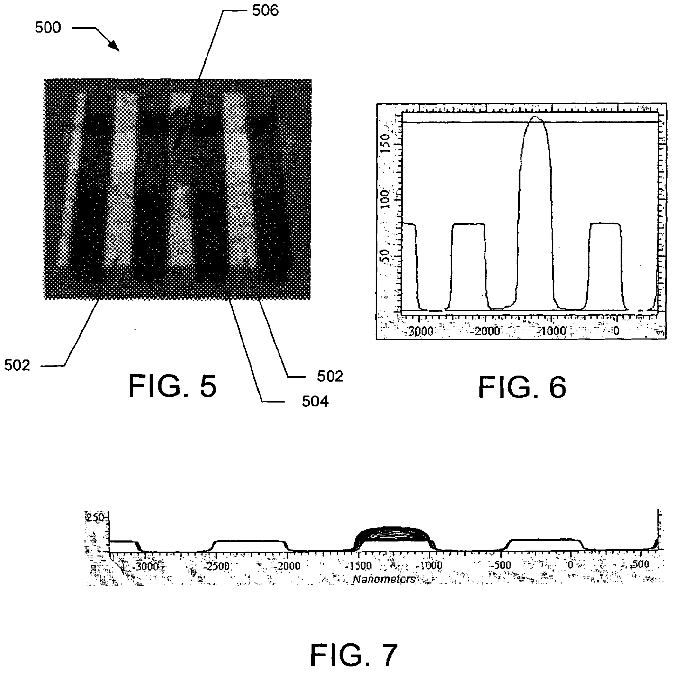

FIG. 5 shows a three dimensional image 500 of the 0.520 $\mu$m lines 502 of MoSiON and spaces 504, with a missing line section repaired by deposition of SiO$_x$ 506. FIGS. 6 and 7 show a cross section of the lines of FIG. 5, with the width to height ratio in FIG. 6 shown not-to-scale to better illustrate the difference in height between the original MoSiON and the SiO$_x$ repair area. The SiO$_x$ is thicker than the adjacent MoSiON because the index of refraction of SiO$_x$ is less than that of MoSiON, so a thicker layer of SiO$_x$ is required to produce the same phase shift as the MoSiON layer. The deposited SiO$_x$ is approximately 0.1 $\mu$m by 1 $\mu$m and 168 nm tall and was applied using a dose of 0.1571 nC/$\mu$m$^2$.

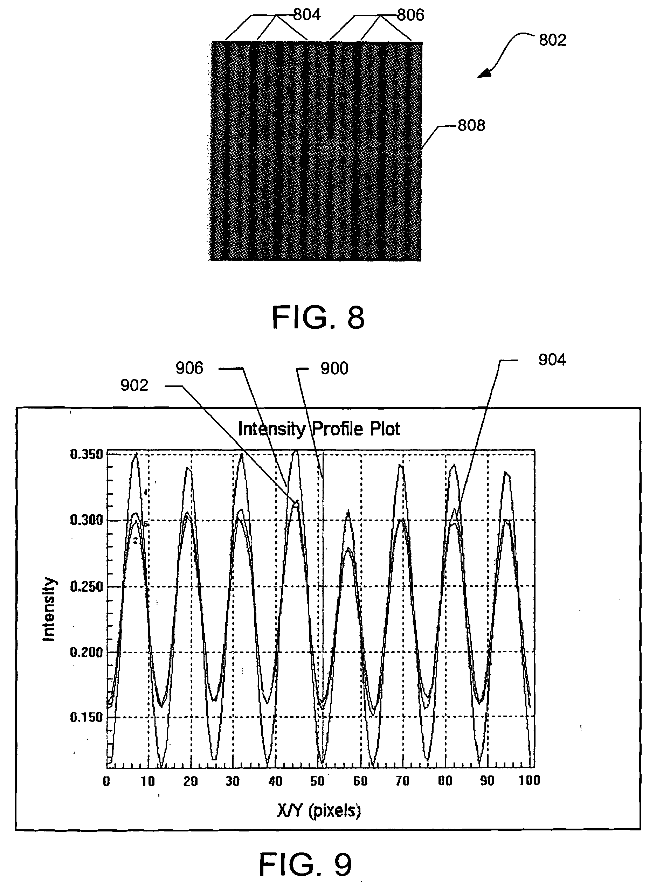

In step 408, the aerial image of the various test sites are observed on an AIMS system. FIG. 8 shows an aerial image 802 of a test mask pattern that includes a repaired area. The aerial image can be obtained, for example, using an Aerial Image Measurement System (AIMS) from Carl Zeiss SMP AG, Oberkochen, Germany. The aerial image 802 includes a pattern of dark lines 804 and light lines 806 corresponding to absorber material and lack of absorber material on the mask. The repair whose image is shown in FIG. 8 was applied using a dose of 0.1286 nC/$\mu$m$^2$

In step 410, the light intensity under each of the test sites is determined. FIG. 9 shows a plot of the intensity of light along a line 808 in the image of FIG. 8, the line 808 running under a test site perpendicular to the lines and spaces on the mask near a test site. Line 900 corresponds to a position below the center of the test site. Graph line 902 shows the intensity in a focal plane, and lines 904 and 906 shows the intensity 6.4 micron above and below, respectively, the focal plane. The higher intensity to the left of the repair (i.e., left of line 900) and the lower intensity to the right of the repair are thought to be caused by a drift of 25-30 nm in the ion beam position and such artifacts can be readily controlled. The intensity at the focal plane under the repair site is used as the value of the intensity of that repair. The intensity for each of the multiple repair sites is determined.

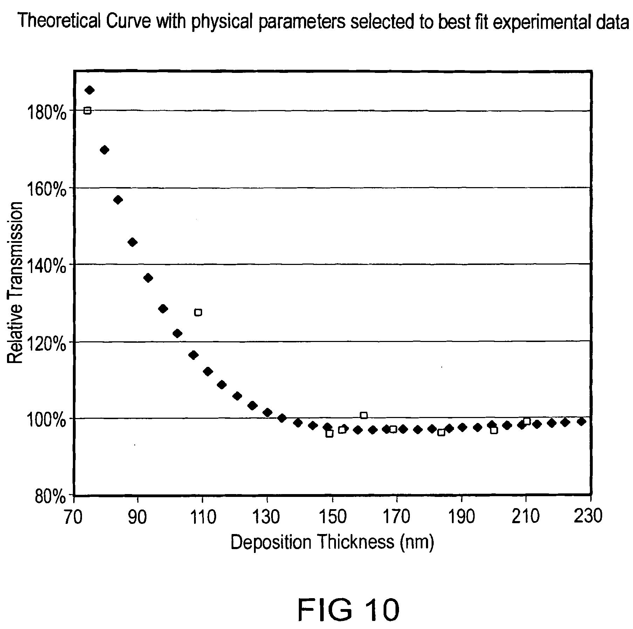

In step 412, the intensity below each of the repair sites is plotted, and a curve is fitted to the plotted points to define a relationship between thickness and intensity. FIG. 10 shows a graph of transmission versus deposition thickness. The transmission value is normalized such that transmission under a section without a defect is 100 percent. The square points of FIG. 10 represent measured values, and the diamond points represent a best fit line calculated to fit the measured values.

In step 414, the thickness that minimizes the intensity under the repaired area determined from the curve. In the case of FIG. 10, the theoretical curve that best fit the measured data points reaches its minimum value near deposition thickness of 160 nm. This thickness is presumed to provide the necessary 180 degree phase shift.

After determining the optimum thickness in steps 404 to 414 to provide the required phase shift, the next several steps determine process parameters that provide the required attenuation. Applicants have found that the attenuation per unit thickness of a deposition can be controlled by varying the gallium concentration, and the gallium concentration can be controlled relatively independently of the deposition thickness by adjusting process parameters other than dose. For example, the gallium concentration can be controlled by adjusting dwell time or refresh rate. This control over attenuation per unit thickness is independent of thickness because dose adjustments can be used to account for any effects that dwell time, refresh rate, or process parameters have on deposition rate.

The ion beam typically scans the repair area in a raster pattern. The horizontal scan, rather than being continuous, typically moves from a point, referred to as pixel, to an adjacent, overlapping pixel. The amount of time that the beam sits at each pixel is referred to as the "dwell time." After a line is scanned, the beam is blanked as it moves rapidly back to the beginning of the next line and then the beam processes the next line. In some embodiments, the beam is moved boustrophedonically, that is, in a serpentine pattern, processing every other line while moving in the opposite direction. In yet another embodiment, the beam can move from point to point, without concern for rows or column.

After an entire repair area is processed, the beam is blanked, moved back to the beginning of the repair area, and the repair area is processed again. The time delay from the end of one repetition to the beginning of the next is referred to as the refresh time.

A repair typically requires many repetitions. The deposition is not typically performed in a single long duration scan over the area because the deposition gas adsorbed on the surface at a pixel is depleted while the beam dwells there. It is generally thought that precursor gases do not react with the ion beam unless the precursor is adsorbed onto the mask surface near the ion impact area. The beam must therefore move relatively quickly from pixel to pixel to avoid depleting the adsorbed precursor gas, and the refresh time is set to allow additional precursor gas to be adsorbed between beam passes. A longer dwell time or a shorter refresh time allows for greater depletion of the adsorbed precursor gas, so more gallium is implanted without contributing to increasing thickness by decomposing precursor gas molecules.

To begin determining process parameters to provide the required attenuation, multiple test areas, about 3.0 $\mu$m by 3.0 $\mu$m, are deposited in step 420 to characterize the effect of dwell time and refresh rate on transmissivity. Larger test areas are used for determining the attenuation than for determining the phase shift because diffraction effects can interfere with bulk transmissivity measurements in small test areas. The size of the test areas was limited by the fact that the time necessary to raster the beam through the entire test area must be less than the refresh time being tested.

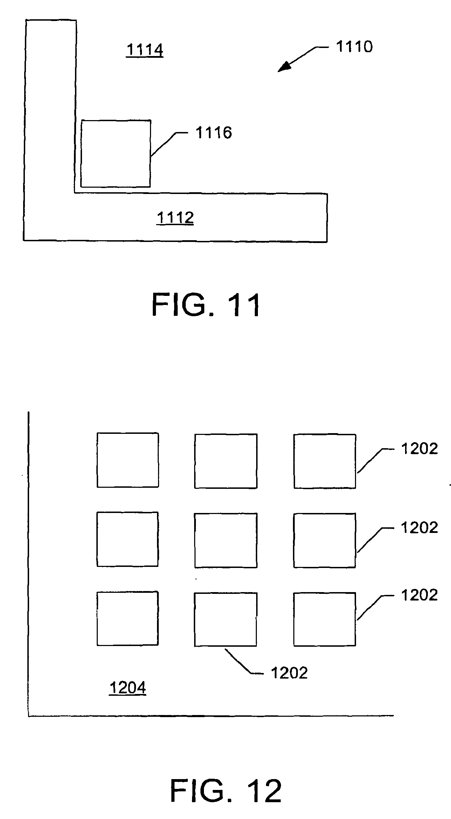

FIGS. 11 and 12 show examples of different test site configurations for determining attenuation. FIG. 11 is a mask 1110 that includes a MoSiON on quartz area 1112, a quartz area 1114, and a test area 1116. FIG. 12 shows multiple test areas 1202 on quartz 1204. The test sites for determining transmissivity are larger than the sites for determining phase shift, to reduce diffraction effects. The depositions were performed using a focused ion beam with an acceleration voltage of about 30 kV, a TMCTS pressure of 1.0 mbar, a variable oxygen pressure, a beam current of 2.7 pA. The dose, which was determined based upon the thickness required to provide a desired phase shift, was 0.160 nC/$\mu$m$^2$, and a pixel spacing of 0.02 $\mu$m was used.

Dwell time and refresh time were varied for different test areas. It is believed that these parameters affect the attenuation per unit thickness of the deposition through their effect on the gallium concentration. There was a correlation between these parameters and the attenuation per unit thickness. In step 422, the aerial image of the test areas were observed through an AIMS system, and the average, minimum intensity across the repaired area was measured.

In step 424, the thicknesses of the deposited areas were measured using a surface profilometer. In step 426, the attenuation per unit thickness is determined for by multiplying the logarithm of attenuation found in step 422 by the ratio of unit thickness to the thickness measured in step 424 and taking the inverse logarithm of the result.

In step 428, mathematical relationship between the attenuation per unit thickness and the process parameters that were varied in the test depositions is determined. For example, an equation can be derived from using standard experimental analysis techniques to related attenuation per unit thickness to dwell time and refresh time. Other factors could be used as the independent variables in different applications.

The thickness necessary to provide the desired phase shift was determined previously in step 414. In step 430, the attenuation per unit thickness required to produce the desired attenuation at the repair thickness determined in step 414 is approximated as follows:

$$\text{Attenuation factor per unit thickness} = \text{Exp} \left[ \text{Log}_e \text{ (attenuation required)} / \text{thickness to provide phase shift} * \text{unit thickness} \right]$$

Knowing the required attenuation per unit thickness, the processing parameters, that is, the dwell time and refresh time can be determined from the relationship found in step 434. In step 436, the ion dose is determined, based on the process parameters determined in step 426 and the thickness determined in step 414. In step 438, a technician programs the FIB machine with the ion dose from step 436 and the process parameters from step 434 and performs the repair.

While the inventors describe above the details of a specific embodiment of a general deposition process, it is understood that there are alternative characterization and optimization methods that could be used. For example, the result of steps 405 through 414 could be presumed using the equation shown in paragraph 1055, allowing steps 405 through 414 to be ignored. Another alternative is to characterize the effect of process parameters on attenuation per unit thickness (steps 420 through 428) before identifying the necessary deposition thickness (steps 405 through 414). Instead of performing the analysis described in steps 410 through 414, one could perform a through-focus analysis of AIMS captures of repair areas. Skilled persons will be aware of other alternate methods of accomplishing the same goals as in the above steps. Such alternate methods do not depart from the scope of the invention.

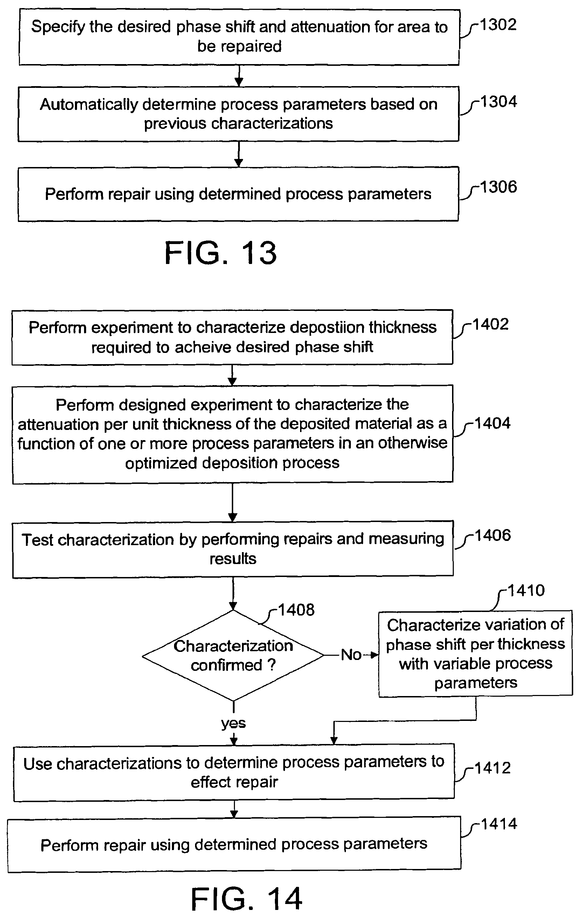

The steps described above show how to determine process parameters setting to achieve a specified phase shift and attenuation. Once the relationships among thickness, phase shift, and dose are known, and the relationships among the attenuation, dwell time, and refresh time are known, those relationships can be used to program future repairs. The process can then be "tuned" to achieve a range of desired combinations of phase shift and transmissivity can be matched without little or no additional characterization testing. A technician will thus be able merely to specify the desired phase shift and attenuation, and a program that incorporates the relationships can determine the dose and process parameters and effect the repair. FIG. 13 shows that a repair technician need only specify the desired phase shift and attenuation in step 1302, and the process parameters are automatically determined in step 1304. The repair is then completed in step 1306.

While the steps shown above are described for gallium focused ion beam deposition, the teachings can be applied to electron beam or laser deposition by using the appropriate process parameters.

The steps of FIGS. 4A and 4B assume that the index of refraction is independent of the concentration of implanted gallium, so that the attenuation, which is caused by the implanted gallium, can be adjusted independently of the phase shift, which is determined by the thickness of the deposited layer and its index of refraction. This assumption is workable for various materials that can be deposited by tools for phase shift mask repair.

The steps of FIGS 4A and 4B can be considered to be part of a generalized process shown in FIG. 14, the generalized process being suitable for use with ion beam, electron beam, laser induced, or other localized deposition process. In step 1402, an experiment is performed to determine the thickness of material (such as Ga implanted SiOx) that will produce various desired phase shifts, typically including $\pi$ radians, in transmitted light relative to clear quartz area at the lithographic wavelength. In step 1404, a designed experiment is performed to characterize the attenuation per unit thickness of the deposited material as a function of one or more process parameters in an otherwise optimized deposition process. In step 1406, the results of the previous steps are tested by depositing repairs of the same thickness for each of the parameter values measured in step 1404 using the calculated doses. The transmittance is then measured and the phase effects analyzed to determine if the phase shift varies significantly from the desired phase shift across the series of depositions. If the phase shift is found in step 1408 to vary with the concentration of contaminants, then step 1410 characterizes the relationship between the two, and the algorithm that determines process parameters from the desired phase shift and attenuation is adjusted accordingly. Repairs can then be performed in step 1414 and process parameters determined based on the desired output parameters.

If, in an embodiment in which the index of refraction varies significantly with the level of contamination, one can follow conventional experiment design techniques, using dose, dwell time, and refresh time as independent variable, and transmission and phase shift as response variable, to determine relationships between the process factors and the phase shift and attenuation of the repaired area. Applying the designed experiment to the process of example 1 will produce similar results as described above, because the implanted gallium has only a negligible impact on the index of refraction. If the contaminant increased the index of refraction, the calculated thickness would decrease as the attenuation and therefore the contaminants increased.

It is understood that using a focused beam of gallium ions to deposit material will necessarily implant gallium and cause some attenuation because gallium is an essential part of the gallium ion beam induced deposition process. In other embodiments, for example, when using electron beam or laser induced deposition, deposition of a phase shifting material can be performed with little or no attenuation. In such a case, the model of independently determining a process parameter to match the phase shift and a process parameter for matching the attenuation is more accurate.

In a preferred embodiment of the invention, the deposited material exactly matches or closely matches both the phase-shifting and attenuating properties of the missing material. Alternative embodiments of the invention may deposit a material that partially matches the phase-shifting and attenuation properties of the missing material. Partially matching the desired properties of missing material can improve the quality of the aerial image of a damaged PSM better than leaving a defect unrepaired and better than the conventional repair method of replacing the missing material with an opaque material. Embodiments of the invention may tune the deposition to the best combination of optical properties for repair when physical limitations of an implementation of the invention prevent an exact match to the properties of the material missing from the mask. Embodiments of the invention may also be tuned to deposit material with properties that do not match those of the missing material for other reasons as well.

In an embodiment of the invention, non-exact matching of phase and transmissive properties is illustrated by a PSM with a defect consisting of missing absorber material that should be 6% transmissive and induce a 180° phase-shift on passing light. In the case of this mask, depositing a material with near 6% transmissivity and a near 180° phase-shift is preferable to depositing a material with 5% transmissivity and 170° phase-shift (transmission within +/- 1%, phase shift within +/- 10 degrees), which is preferable to depositing a material with 4% transmissivity and a 160° phase-shift (transmission within +/- 2%, phase shift within +/- 20 degrees). However, all three cases are examples of embodiments of the invention. Applicants expect that embodiments of the invention will be used to repair PSMs with absorber material with a wide range of optical properties: PSMs may have absorber material with any useful transmissivity including 6%, 8%, 20%, 50%, and 100%; and any useful phase-shift including 60°; 120°, 180°; and 270°. Matching accuracy is, in order of increasing preference, preferably within plus or minus 70% (for example, for a mask with a design transmission of 10%, deposited material transmits between 3% and 17% of incident light), 50%, 30 %, 20%, 10%, 5%, 2%, or 1% of the design transmission value, and matching of phase shift is preferably, in order of increasing preference, within 90°, 60°, 30°, 20°, 10°, 5°, 3° or 1° of the design phase shift.

In some embodiments in which an electron beam or a laser is used to provide the energy to decompose a precursor to deposit material, ions can be used to implant the deposited material into the surface.

The term "light" as used herein is not limited to radiation in the visible portion of the spectrum, and can include any exposing radiation, such ultraviolet or x-rays.

Applicants have also found that Siloxane compounds can also be used to deposit an opaque material. For example, one can use a FIB to induce deposition using TMCTS gas without introduced oxygen to deposit a layer of opaque material for the replacement of missing opaque absorber material on photomasks. The transmission of the deposited material is essentially zero.

One example of a FIB repair process tuned for the replacement of missing opaque material could use the following parameters.

| Variable | Unit | Value |
|---|---|---|
| Accel voltage | kV | 30.0 |
| TMCTS Pressure | mbar | 1.0 |
| O2 Pressure | mbar | 0.0 |
| Beam current | pA | 6.0 |
| Repair area | $\mu m^2$ | 0.500 |
| Repair dose | $nC/\mu m^2$ | 0.100 |
| Pixel spacing | $\mu m$ | 0.020 |
| Dwell time | $\mu s$ | 0.500 |
| Refresh time | Ms | 3.0 |

Skilled persons will understand that many known techniques are used to align repairs with missing material and to compensate for edge effects at the edges of a repair. These techniques are well known and not described herein.

Although the present invention and its advantages have been described in detail, it should be understood that various changes, substitutions and alterations can be made herein without departing from the spirit and scope of the invention as defined by the appended claims. The invention achieves multiple objectives and because the invention can be used in different applications for different purposes, not every embodiment falling within the scope of the attached claims will achieve every objective. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

**Claims**

1. A method of locally depositing a material having a specified phase shift and transmission at a specified wavelength of light, comprising:

   depositing a material in a localized area, the material having a thickness such as to provide a desired, non-zero phase shift relative to a substrate; and
   incorporating into the deposited material a contaminant that reduces, but does not eliminate, the transmission through the deposited material so as to provide, at a specified wavelength, a transmission and non-zero phase shift similar to that of the original design.

2. The method of claim 1 in which depositing a material includes depositing a material using an ion beam, an electron beam, or a laser beam to decompose a precursor to said material.

3. The method of claim 2 in which incorporating a contaminant includes incorporating a contaminant that is combined with the precursor during the deposition process and in which the concentration of the contaminant, or other property of the contamination affects the optical properties of the deposited material, can be controlled using process parameters.

4. The method of any of the above claims in which depositing a material includes depositing a material using a beam of gallium ions to induce decomposition of a precursor material and in which incorporating into the deposited material a contaminant includes incorporating gallium from the ion beam into the deposited material.

5. The method of claim 4 in which depositing material using a beam of gallium ions to induce decomposition of a precursor material includes using a beam of gallium ions to induce decomposition of a siloxane compound in combination with oxygen or an oxygen bearing compound.

6. The method of any of the above claims in which the deposited material comprises silicon and an oxide.

7. The method of any of the above claims in which the deposited material comprises silicon in combination with nitrogen bearing compounds.

8. The method of claim 1 in which depositing a material includes depositing material using a beam of electrons or a laser beam to induce decomposition of a precursor material and also includes depositing material using ions.

9. The method of claim 8 in which the ions are implanted into the material deposited by the beam of electrons or laser beam induced decomposition, where the ion beam does not substantially decompose the deposited material.

10. The method of claim 8 in which the ions are used to induce the decomposition of a precursor material and in which the ions are incorporated into the deposited material as a contaminate that reduces the transmission of the deposited material

11. The method of claim 2 in which incorporating a contaminant includes mixing a carbon-containing gas with the precursor gas, the carbon-containing gas decomposing to incorporate carbon into the deposited material.

12. The method of claim 11 in which the carbon-containing gas comprises styrene.

13. The method of claim 1 in which incorporating a contaminant includes incorporating a contaminant unavoidably or unintentionally present in a mask repair system.

14. The method of claim 1 in which incorporating a contaminant includes incorporating a contaminant intentionally introduced in a mask repair system.

15. The method of claim 1 in which depositing a material using beam deposition includes depositing a material using a scanning probe microscope.

16. An attenuated phase shift lithography mask including areas of an absorber material that transmits a portion of incident light phase shifted compared to incident light that does not pass through the absorber material, comprising:

   areas of a first absorber material, the areas of the first absorber material attenuating the incident light and transmitting a portion of incident light phase shifted compared to incident light that does not pass through the absorber material;
   areas that lack absorber material and that transmit incident light without significant attenuation compared to the areas having absorber material;
   at least one area of a second absorber material, having a different composition from that of the first absorber material, the second absorber material attenuating the incident light and transmitting a portion of incident light phase shifted compared to incident light that does passes through areas that lack absorber material, the attenuation and the phase shift through the at least one area of a second absorber material being approximately the same as that of the first absorber material, so as to produce an aerial image that is closer to that of the first absorber material than that of an opaque material.

17. The attenuated phase shift lithography mask of claim 16 in which the areas of the first absorber material have a first thickness and in which the areas of the second absorber material have a second thickness, the first and second thicknesses being different.

18. The attenuated phase shift lithography mask of either of claims 16 or 17 in which the first absorber material comprises MoSiON and the second absorber material comprises $SiO_x$ with an incorporated contaminant.

19. The attenuated phase shift lithography mask of any of claims 16-18 in which the incorporated contaminant comprises gallium or carbon.

**FIG. 1**

**FIG. 2**

**FIG. 3**

Determine phase shift and attenuation required of repair — 402

Estimate thickness of deposited layer required to provide phase shift — 404

Convert thickness values to doses — 405

Deposit material at multiple test sites — 406

Measure aerial image of test sites — 408

Plot intensity under test sites — 410

Define relationship between thickness and intensity — 412

Determine thickness that minimizes intensity — 414

A

# FIG. 4A

```
                              ┌───┐
                              │ A │
                              └─┬─┘
                                ▼
┌──────────────────────────────────────────────────────┐
│ Deposit multiple large area varying dwell time and     │  ⟋ 420
│                    refresh time                         │
└──────────────────────────┬─────────────────────────────┘
                           ▼
┌──────────────────────────────────────────────────────┐
│      Determine transmission from aerial image           │  ⟋ 422
└──────────────────────────┬─────────────────────────────┘
                           ▼
┌──────────────────────────────────────────────────────┐
│                   Measure thickness                     │  ⟋ 424
└──────────────────────────┬─────────────────────────────┘
                           ▼
┌──────────────────────────────────────────────────────┐
│ Determine relationship between proecss variables and    │  ⟋ 425
│                   deposition rate                       │
└──────────────────────────┬─────────────────────────────┘
                           ▼
┌──────────────────────────────────────────────────────┐
│         Calculate attenuation per unit thickness        │  ⟋ 426
└──────────────────────────┬─────────────────────────────┘
                           ▼
┌──────────────────────────────────────────────────────┐
│ Determine relationship between process variables and    │  ⟋ 428
│              attenuation per unit thickness             │
└──────────────────────────┬─────────────────────────────┘
                           ▼
┌──────────────────────────────────────────────────────┐
│ Determine required attenuation per unit thickness from  │  ⟋ 430
│   required thickness (step 414) and desired attenuation │
└──────────────────────────┬─────────────────────────────┘
                           ▼
┌──────────────────────────────────────────────────────┐
│ Determine process parameters from required attenuation  │  ⟋ 434
│  per unit thickness and relationship found in step 428  │
└──────────────────────────┬─────────────────────────────┘
                           ▼
┌──────────────────────────────────────────────────────┐
│ Determine ion dose based on thickness determine from    │  ⟋ 436
│   step 426 and deposition rates from step 425           │
└──────────────────────────┬─────────────────────────────┘
                           ▼
┌──────────────────────────────────────────────────────┐
│ Perform repair using process parameters from step 434   │  ⟋ 438
│              and dose from step 436                     │
└──────────────────────────────────────────────────────┘
```

# FIG. 4B

FIG. 5

FIG. 6

FIG. 7

804    806

802

808

# FIG. 8

906    900    904

902

## Intensity Profile Plot

# FIG. 9

Theoretical Curve with physical parameters selected to best fit experimental data

FIG 10

FIG. 11

FIG. 12

Specify the desired phase shift and attenuation for area to be repaired ⌐1302

↓

Automatically determine process parameters based on previous characterizations ⌐1304

↓

Perform repair using determined process parameters ⌐1306

# FIG. 13

Perform experiment to characterize depostiion thickness required to acheive desired phase shift ⌐1402

↓

Perform designed experiment to characterize the attenuation per unit thickness of the deposited material as a function of one or more process parameters in an otherwise optimized deposition process ⌐1404

↓

Test characterization by performing repairs and measuring results ⌐1406

↓

⌐1408
Characterization confirmed ? —No→ Characterize variation of phase shift per thickness with variable process parameters ⌐1410

yes
↓

Use characterizations to determine process parameters to effect repair ⌐1412

↓

Perform repair using determined process parameters ⌐1414

# FIG. 14

21